# EUROPEAN PATENT APPLICATION

(11) **EP 4 589 591 A1**
(43) Date of publication of application: **23.07.2025**
(21) Application number: 25151468.3
(22) Date of filing: 13.01.2025
(51) Int. Cl.: G11C 11/16

(54) **SEMICONDUCTOR DEVICE**

(30) Priority: 22.01.2024 KR 20240009467
(71) Applicant: Samsung Electronics Co., Ltd., Suwon-si, Gyeonggi-do 16677 (KR)
(72) Inventor: LEE, Jae Hong, 16678 Suwon-si (KR); JANG, Hyeongseok, 16678 Suwon-si (KR); CHO, Won Joon, 16678 Suwon-si (KR); KIM, Jaewon, 16678 Suwon-si (KR); KIM, Taehoon, 16678 Suwon-si (KR); YOUN, Hyungjun, 16678 Suwon-si (KR); LEE, Woochang, 16678 Suwon-si (KR)
(74) Representative: Elkington and Fife LLP

(57) **Abstract**

A semiconductor device includes: a reference layer having a fixed spin direction; a metal layer disposed below the reference layer; a first free layer disposed below the metal layer; a first spin orbit coupling (SOC) layer disposed below the first free layer, and configured to control a spin direction recorded in the first free layer by using a current flowing through the first SOC layer; a second free layer disposed below the first SOC layer; and a second SOC layer disposed below the second free layer, and configured to control a spin direction recorded in the second free layer by using a current flowing through the second SOC layer.

## Description

### FIELD OF THE INVENTION

The present disclosure relates to a semiconductor device.

### BACKGROUND OF THE INVENTION

A magnetic random-access memory (MRAM) implemented by a nonvolatile memory technology for storing data by using a magnetic property may maintain the data even when power is turned off, and provide faster readout and write performance and improved durability than a traditional dynamic random-access memory (DRAM). A MRAM cell may include a magnetic tunnel junction (MTJ), which includes a reference layer (or fixed layer), a free layer, and a tunneling layer formed between the reference layer and the free layer, and a spin orbit coupling (SOC) layer having a spin direction recorded in the free layer. The spin direction may be recorded in the free layer through a current flowing through the SOC layer, and a resistance value between the free layer and the reference layer may be changed based on whether the spin direction recorded in the free layer is the same as the spin direction recorded in the reference layer. One type of the MRAM may include a spin transfer torque magnetic random-access memory (STT-MRAM), and another type of the MRAM may include a spin orbit torque magnetic random-access memory (SOT-MRAM) which may provide greater stability and faster driving speed by separating current paths for the readout and the write from each other, compared to the STT-MRAM.

### SUMMARY OF THE INVENTION

The present disclosure attempts to provide a semiconductor device having a minimum occupancy area and fewer transistors required for its operation.

According to an embodiment, provided is a semiconductor device including: a reference layer having a fixed spin direction; a metal layer disposed below the reference layer; a first free layer disposed below the metal layer; a first spin orbit coupling (SOC) layer disposed below the first free layer, and configured to control a spin direction recorded in the first free layer by using a current flowing through the first SOC layer; a second free layer disposed below the first SOC layer; and a second SOC layer disposed below the second free layer, and configured to control a spin direction recorded in the second free layer by using a current flowing through the second SOC layer.

A barrier layer may be disposed between the reference layer and the metal layer, between the metal layer and the first free layer, or between the first SOC layer and the second free layer.

The device may further include: a first transistor controlled by a first word line signal to selectively connect the metal layer and a source line to each other; a second transistor controlled by a second word line signal to selectively connect the first SOC layer and the source line to each other; and a third transistor controlled by a third word line signal to selectively connect the second SOC layer and the source line to each other.

The first SOC layer may be connected to a write bit line, the first SOC layer may be connected to the source line through the second transistor, and the spin direction of the first free layer may be determined based on the current flowing through the first SOC layer between the write bit line and the source line.

The second SOC layer may be connected to the write bit line, the second SOC layer may be connected to the source line through the third transistor, and the spin direction of the second free layer may be determined based on the current flowing through the second SOC layer between the write bit line and the source line.

The device may further include a readout transistor configured to selectively connect the reference layer and a readout bit line to each other, wherein the reference layer is connected to the readout bit line through the readout transistor, the first SOC layer is connected to the source line through the second transistor, and the spin direction of the first free layer is determined by measuring a resistance value of a first stacked structure including the reference layer, the metal layer, the first free layer, and the first SOC layer.

The spin direction of the reference layer and the spin direction of the first free layer may be determined to be opposite to each other when the measured resistance value of the first stacked structure is a first critical value or more, and the spin direction of the reference layer and the spin direction of the first free layer may be determined to be the same as each other when the measured resistance value of the first stacked structure is less than the first critical value.

The metal layer may be connected to the source line through the first transistor, the second SOC layer may be connected to the source line through the third transistor, and the spin direction of the second free layer may be determined by measuring a resistance value of a second stacked structure including the reference layer, the metal layer, the first free layer, the first SOC layer, the second free layer, and the second SOC layer.

The spin direction of the first free layer and the spin direction of the second free layer may be determined to be opposite to each other when the measured resistance value of the second stacked structure is a second critical value or more, and the spin direction of the first free layer and the spin direction of the second free layer may be determined to be the same as each other when the measured resistance value of the second stacked structure is less than the second critical value.

According to an embodiment, provided is a semiconductor device including: a reference layer having a fixed spin direction; a first free layer disposed below the reference layer; a first spin orbit coupling (SOC) layer disposed below the first free layer, and configured to control a spin direction recorded in the first free layer by using a current flowing through the first SOC layer; a second free layer disposed below the first SOC layer; and a second SOC layer disposed below the second free layer, and configured to control a spin direction recorded in the second free layer by using a current flowing through the second SOC layer.

A barrier layer may be disposed between the reference layer and the first free layer, or between the first SOC layer and the second free layer.

The device may further include: a first transistor controlled by a first word line signal to selectively connect the first SOC layer and a source line to each other; and a second transistor controlled by a second word line signal to selectively connecting the second SOC layer and the source line to each other.

The first SOC layer may be connected to a write bit line, the first SOC layer may be connected to the source line through the first transistor, and the spin direction of the first free layer may be determined based on the current flowing through the first SOC layer between the write bit line and the source line.

The second SOC layer may be connected to the write bit line, the second SOC layer may be connected to the source line through the second transistor, and the spin direction of the second free layer may be determined based on the current flowing through the second SOC layer between the write bit line and the source line.

The device may further include a readout transistor configured to selectively connect the reference layer and a readout bit line to each other, wherein the reference layer is connected to the readout bit line through the readout transistor, the first SOC layer is connected to the source line through the first transistor, and the spin direction of the first free layer is determined by measuring a first resistance value of a first stacked structure including the reference layer, the first free layer, and the first SOC layer.

The reference layer may be connected to the readout bit line through the readout transistor, the second SOC layer may be connected to the source line through the second transistor, and the spin direction of the second free layer may be determined by measuring a second resistance value of a second stacked structure including the reference layer, the first free layer, the first SOC layer, the second free layer, and the second SOC layer.

The spin direction of the first free layer and the spin direction of the second free layer may be determined to be opposite to each other when a difference between the first resistance value and the second resistance value is measured to be a third critical value or more, and the spin direction of the first free layer and the spin direction of the second free layer may be determined to be the same as each other when the difference between the first resistance value and the second resistance value is measured to be less than the third critical value.

According to an embodiment, provided is a semiconductor device including: a reference layer having a fixed spin direction; a first free layer disposed below the reference layerand having a physical property in which a resistance value of the first free layer is determined a value corresponding to a first digit of a ternary number, based on a spin direction of the first free layer; a first spin orbit coupling (SOC) layer disposed below the first free layer, and configured to control the spin direction of the first free layer by using a current flowing through the first SOC layer; a second free layer disposed below the first SOC layer and having a physical property in which a resistance value of the second free layer is determined to a value corresponding to a second digit of the ternary number, based on a spin direction of the second free layer; and a second SOC layer disposed below the second free layer, and configured to control the spin direction of the second free layer by using a current flowing through the second SOC layer.

A barrier layer may be disposed between the reference layer and the first free layer, or between the first SOC layer and the second free layer.

The spin directions of the first free layer and the second free layer may be determined by converting a resistance value measured between the reference layer and the second SOC layer to the ternary number.

### BRIEF DESCRIPTION OF THE DRAWINGS

FIG. 1 is a diagram showing a semiconductor device according to an embodiment.
FIGS. 2 and 3 are diagrams showing a write operation of the semiconductor device according to an embodiment.
FIGS. 4 to 7 are diagrams showing a readout operation of the semiconductor device according to an embodiment.
FIG. 8 is a diagram showing a semiconductor device according to another embodiment.
FIGS. 9 to 11 are diagrams showing a readout operation of the semiconductor device according to an embodiment.
FIG. 12 is a diagram showing a semiconductor device according to still another embodiment.
FIGS. 13 and 14 are diagrams showing a readout operation of the semiconductor device according to an embodiment.
FIG. 15 is a block diagram showing a system including the semiconductor device according to an embodiment.

### DETAILED DESCRIPTION

Hereinafter, embodiments of the present disclosure are described in detail with reference to the accompanying drawings so that those skilled in the art to which the present disclosure pertains may easily practice the present disclosure. However, the present disclosure may be implemented in various different forms and is not limited to the embodiments described herein. In addition, in the drawings, portions unrelated to the description are omitted to clearly describe the present disclosure, and similar portions are denoted by similar reference numerals throughout the specification.

Through the specification and claims, unless explicitly described otherwise, "including" any components will be understood to imply the inclusion of another component rather than the exclusion of another component. Terms including ordinal numbers such as "first", "second", and the like, may be used to describe various components. However, these components are not limited by these terms. This term is used only to distinguish one component from another component.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

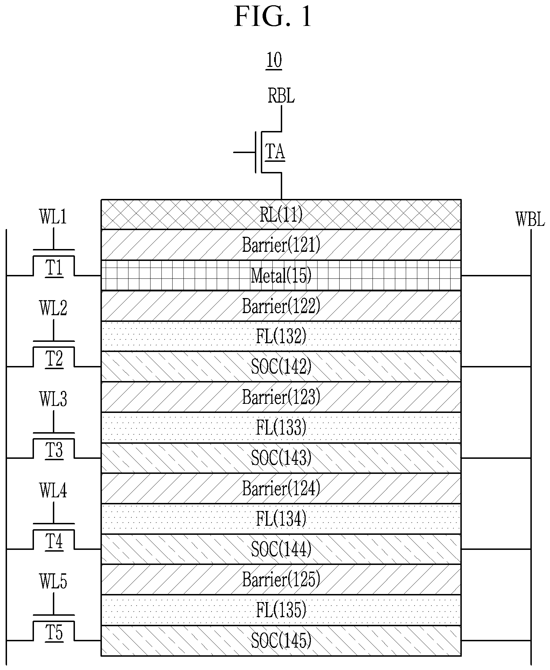

FIG. 1 is a diagram showing a semiconductor device according to an embodiment.

Referring to FIG. 1, a semiconductor device 10 according to an embodiment may include a reference layer 11, a plurality of barrier layers 121 to 125, a plurality of free layers 132 to 135, a plurality of spin orbit coupling (SOC) layers 142 to 145, and a metal layer 15. As shown in the drawing, the semiconductor device 10 may have a vertically stacked structure in which the barrier layers, the free layers, and the SOC layers are repeatedly stacked.

The reference layer 11 may have a fixed spin direction. The reference layer 11 may include at least one of iron (Fe), cobalt (Co), and nickel (Ni), or include at least one of boron (B), silicon (Si), zirconium (Zr), platinum (Pt), palladium (Pd), copper (Cu), and tungsten (W).

The barrier layers 121 to 125 may each be made of an insulating material that is thin enough for electrons to move through tunneling, for example, few nanometers (nm) thick. The barrier layers 121 to 125 may each be made of a material such as magnesium oxide (MgO) or aluminum oxide (Al₂O₃). In general, MgO may be widely used because MgO has a relatively high tunnel magnetoresistance (TMR) ratio, and is thus good in terms of performance and stability. However, Al₂O₃ may still be used in some applications.

The free layers 132 to 135 may have spin directions switchable by currents flowing the SOC layers 142 to 145, respectively. The free layers 132 to 135 may each include at least one of iron (Fe), cobalt (Co), and nickel (Ni), or include at least one of boron (B), silicon (Si), zirconium (Zr), platinum (Pt), palladium (Pd), copper (Cu), and tungsten (W).

The SOC layers 142 to 145 may be layers for respectively recording specific spin directions in the free layers 132 to 135 by using the current. The SOC layers 142 to 145 may each include ruthenium (Ru), aluminum (Al), tantalum (Ta), platinum (Pt), tungsten (W), palladium (Pd), zirconium (Zr), copper (Cu), or an alloy thereof.

In the vertically stacked structure, the metal layer 15 may be disposed below the reference layer 11. Here, the metal layer 15 may include a metal material including copper (Cu). The free layer 132 may be disposed below the metal layer 15, and the SOC layer 142 may be disposed below the free layer 132. The SOC layer 142 may have the specific spin direction recorded in the free layer 132 by using the current. In addition, the free layer 133 may be disposed below the SOC layer 142, and the SOC layer 143 may be disposed below the free layer 133. The SOC layer 143 may have the specific spin direction recorded in the free layer 133 by using the current. In a similar pattern, the following layers may be disposed below the SOC layer 143: the free layer 134, the SOC layer 144 for recording the specific spin direction in the free layer 134, the free layer 135, and the SOC layer 145 for recording the specific spin direction in the free layer 135.

Meanwhile, the barrier layer 121 may be disposed between the reference layer 11 and the metal layer 15. In addition, the barrier layer 122 may be disposed between the metal layer 15 and the free layer 132. In addition, the barrier layers 123, 124, and 125 may respectively be disposed between the SOC layer 142 and the free layer 133, between the SOC layer 143 and the free layer 134, and between the SOC layer 144 and the free layer 135.

The semiconductor device 10 may further include a plurality of transistors T1 to T5. The transistor T1 may be controlled by a word line signal WL1 to selectively connect the metal layer 15 and a source line to each other, the transistor T2 may be controlled by a word line signal WL2 to selectively connect the SOC layer 142 and the source line to each other, and the transistor T3 may be controlled by a word line signal WL3 to selectively connect the SOC layer 143 and the source line to each other. In a similar pattern, the transistor T4 or T5 may be controlled by a word line signal WL4 or WL5 to selectively connect the SOC layer 144 or 145 and the source line to each other. Each of the metal layer 15 and the SOC layer 142, 143, 144, or 145 may have one side connected to the transistor T1, T2, T3, T4, or T5, and the other side connected to a write bit line WBL.

Meanwhile, the semiconductor device 10 may further include a readout transistor TA. The readout transistor TA may selectively connect the reference layer 11 and a readout bit line RBL to each other by a certain control signal.

The scope of the present disclosure is not limited to that shown in FIG. 1, and the number of layers included in the vertically stacked structure may be variously changed based on the specific implementation purpose and implementation environment of the stacked structure. For example, the number of repetitions of the stacked structure disposed below the reference layer 11, the barrier layer 121, and the metal layer 15 and including the free layer, the SOC layer, and the barrier layer may be changed if necessary, and there is no limit to the number of layers to be stacked as long as a process allows.

Hereinafter, the description describes a write operation of performing spin recording in a free layer disposed on a desired SOC layer by flowing the current to the desired SOC layer among the SOC layers 142 to 145 by controlling the transistor T2, T3, T4, or T5.

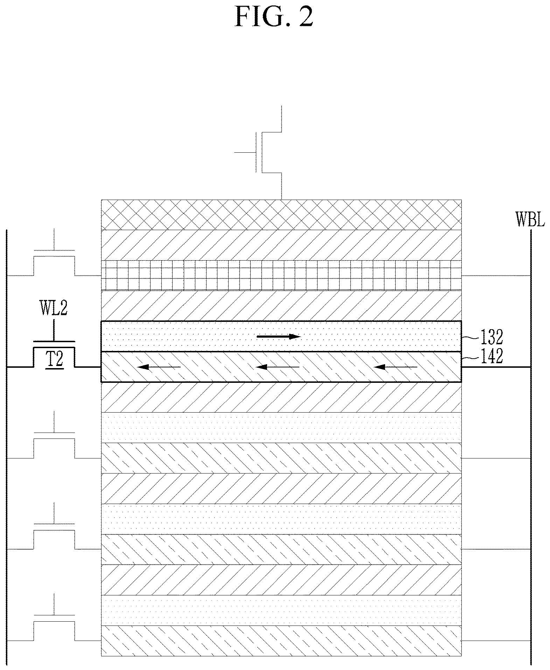

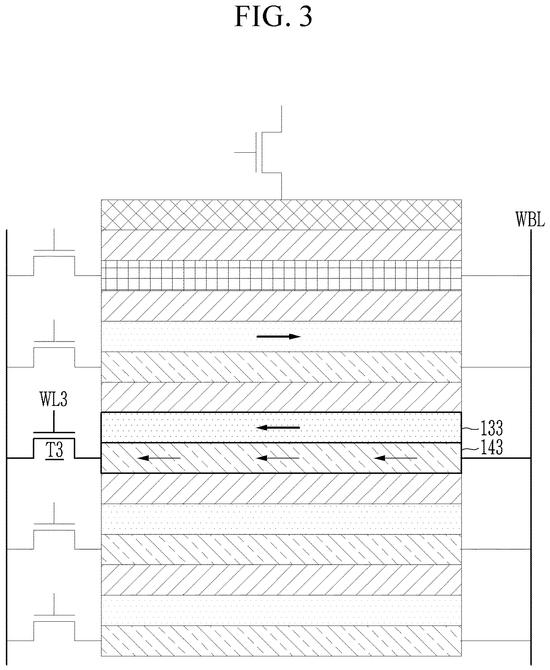

FIGS. 2 and 3 are diagrams showing the write operation of the semiconductor device according to an embodiment.

Referring to FIG. 2, the SOC layer 142 may have one side connected to the source line through the transistor T2, and the other side connected to the write bit line WBL. The transistor T2 may be turned on by the word line signal WL2, and the spin direction of the free layer 132 may be determined based on the current flowing through the SOC layer 142 between the write bit line WBL and the source line.

Next, referring to FIG. 3, the SOC layer 143 may have one side connected to the source line through the transistor T3, and the other side connected to the write bit line WBL. As shown in FIG. 2, the transistor T3 may be turned on by the word line signal WL3 after the spin direction of the free layer 132 is determined, and the spin direction of the free layer 133 may be determined based on the current flowing through the SOC layer 143 between the write bit line WBL and the source line.

In a similar manner, the transistor T4 may be turned on by the word line signal WL4 after the spin direction of the free layer 133 is determined, and the spin direction of the free layer 134 may be determined based on the current flowing through the SOC layer 144. Next, the transistor T5 may be turned on by the word line signal WL5, and the spin direction of the free layer 135 may be determined based on the current flowing through the SOC layer 145.

Hereinafter, the description describes a readout operation of identifying data recorded in the free layer 132, 133, 134, or 135 by the control of the transistor T1, T2, T3, T4, or T5, and the transistor TA. That is, the spin directions of the free layers 132, 133, 134, and 135 may all be determined in the manner described with reference to FIGS. 2 and 3, and the spin directions of the free layers 132, 133, 134, and 135 may then be determined in a manner described below.

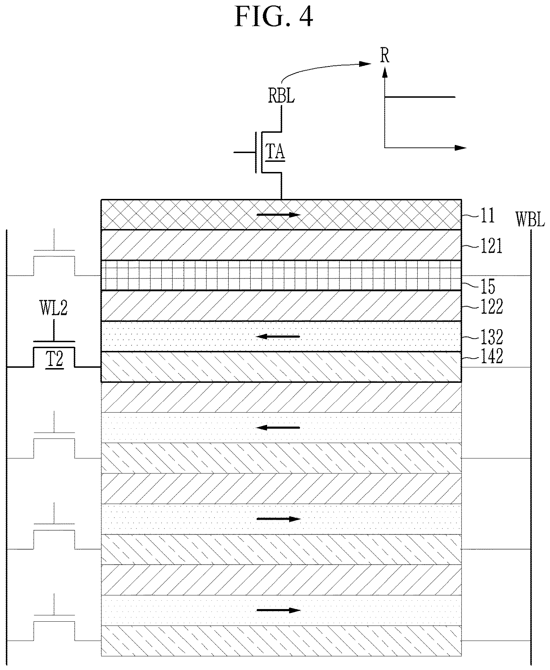

FIGS. 4 to 7 are diagrams showing the readout operation of the semiconductor device according to an embodiment.

Referring to FIG. 4, the reference layer 11 may be connected to the readout bit line RBL by the readout transistor TA, and the SOC layer 142 may be connected to the source line through the transistor T2. When the readout transistor TA and the transistor T2 are turned on, it is possible to measure a resistance value of the stacked structure including the reference layer 11, the metal layer 15, the free layer 132, and the SOC layer 142, and the barrier layers 121 and 122 disposed between these layers. The spin direction of the free layer 132 may be determined by measuring the resistance value.

In detail, the spin direction of the reference layer 11 and the spin direction of the free layer 132 may be determined to be opposite to each other when the resistance value is measured to be a predetermined first critical value or more, and the spin direction of the reference layer 11 and the spin direction of the free layer 132 may be determined to be the same as each other when the resistance value is measured to be less than the first critical value. FIG. 4 shows the case where the resistance value is the predetermined first critical value or more. Here, it may be seen that the spin direction of the reference layer 11 and the spin direction of the free layer 132 are opposite to each other.

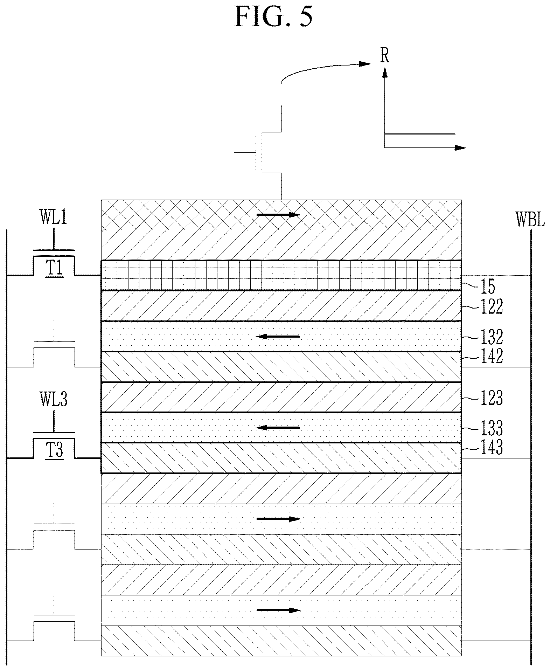

Next, referring to FIG. 5, the metal layer 15 may be connected to the source line through the transistor T1, and the SOC layer 143 may be connected to the source line through the transistor T3. When the transistor T1 and the transistor T3 are turned on, it is possible to measure a resistance value of the stacked structure including the metal layer 15, the free layer 132, the SOC layer 142, the free layer 133, the SOC layer 143, and the barrier layers 122 and 123 disposed between these layers. The spin direction of the free layer 133 may be determined by measuring the resistance value.

In detail, the spin direction of the free layer 132 and the spin direction of the free layer 133 may be determined to be opposite to each other when the resistance value is measured to be a predetermined second critical value or more, and the spin direction of the free layer 132 and the spin direction of the free layer 133 may be determined to be the same as each other when the resistance value is measured to be less than the second critical value. FIG. 5 shows the case where the resistance value is less than the predetermined second critical value. Here, it may be seen that the spin direction of the free layer 132 and the spin direction of the free layer 133 are the same as each other.

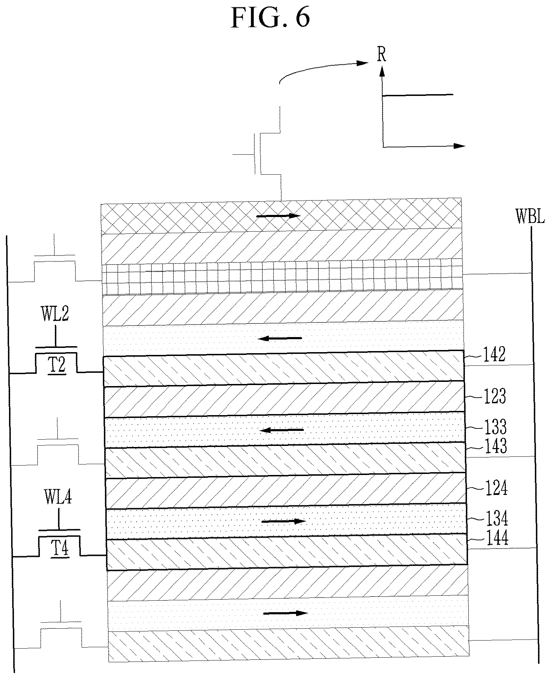

Next, referring to FIG. 6, the SOC layer 142 may be connected to the source line through the transistor T2, and the SOC layer 144 may be connected to the source line through the transistor T4. When the transistor T2 and the transistor T4 are turned on, it is possible to measure a resistance value of the stacked structure including the SOC layer 142, the free layer 133, the SOC layer 143, the free layer 134, the SOC layer 144, and the barrier layers 123 and 124 disposed between these layers. The spin direction of the free layer 134 may be determined by measuring the resistance value.

In detail, the spin direction of the free layer 133 and the spin direction of the free layer 134 may be determined to be opposite to each other when the resistance value is measured to be a predetermined third critical value or more, and the spin direction of the free layer 133 and the spin direction of the free layer 134 may be determined to be the same as each other when the resistance value is measured to be less than the third critical value. FIG. 6 shows the case where the resistance value is the predetermined third critical value or more. Here, it may be seen that the spin direction of the free layer 133 and the spin direction of the free layer 134 are opposite to each other.

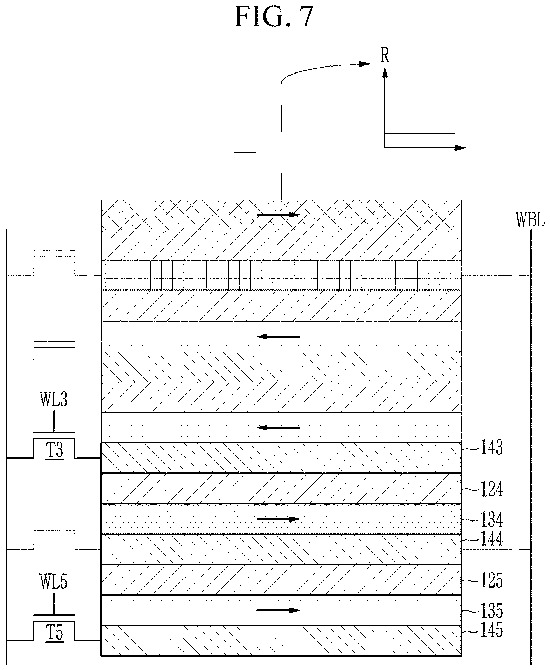

Next, referring to FIG. 7, the SOC layer 143 may be connected to the source line through the transistor T3, and the SOC layer 145 may be connected to the source line through the transistor T5. When the transistor T3 and the transistor T5 are turned on, it is possible to measure a resistance value of the stacked structure including the SOC layer 143, the free layer 134, the SOC layer 144, the free layer 135, the SOC layer 145, and the barrier layers 124 and 125 disposed between these layers. The spin direction of the free layer 135 may be determined by measuring the resistance value.

In detail, the spin direction of the free layer 134 and the spin direction of the free layer 135 may be determined to be opposite to each other when the resistance value is measured to be a predetermined fourth critical value or more, and the spin direction of the free layer 134 and the spin direction of the free layer 135 may be determined to be the same as each other when the resistance value is measured to be less than the fourth critical value. FIG. 7 shows the case where the resistance value is the predetermined fourth critical value or more. Here, it may be seen that the spin direction of the free layer 134 and the spin direction of the free layer 135 are opposite to each other. In this manner, it is possible to identify the spin directions of all the free layers included in the vertically stacked structure.

The above-described first critical value, second critical value, third critical value, and fourth critical value may all be set to the same value, or at least one of these values may be set to a different value.

The semiconductor device 10 of the vertically stacked structure described with reference to FIGS. 1 to 7 may achieve higher bit density while miniaturizing a magnetic tunnel junction (MTJ) and reducing its occupancy area. In addition, the semiconductor device may have fewer transistors required for its operation, thereby implementing more effective scaling down compared to a magnetic random-access memory (MRAM) device having a conventional array form.

In detail, assume for comparison that the vertically stacked structure of the semiconductor device 10 uses the same N free layers, that is, the same data capacity (e.g., N bits). Here, the vertically stacked structure including the N free layers may have the occupancy area reduced to about 1/N of an occupancy area of the MRAM device having the conventional array form. In addition, a conventional spin orbit torque magnetic random-access memory (SOT-MRAM) may require two transistors per one MTJ for its operation. However, the vertically stacked structure according to an embodiment may require fewer transistors for the readout operation. That is, the vertically stacked structure including the N free layers may require only N+2 transistors, and thus be significantly improved over the conventional SOT-MRAM requiring 2N transistors. In addition, the conventional SOT-MRAM sharing some SOT layers may require an additional device to prevent the same data from being recorded in a series of bidirectional bits on a write path. On the other hand, the vertically stacked structure according to an embodiment may require no additional device for the data write.

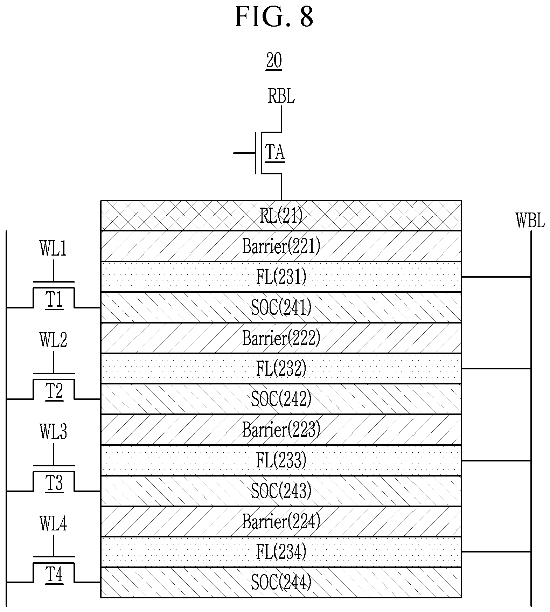

FIG. 8 is a diagram showing a semiconductor device according to another embodiment.

Referring to FIG. 8, a semiconductor device 20 according to an embodiment may include a reference layer 21, a plurality of barrier layers 221 to 224, a plurality of free layers 231 to 234, and a plurality of spin orbit coupling (SOC) layers 241 to 244. As shown in the drawing, the semiconductor device 20 may have a vertically stacked structure in which the barrier layers, the free layers, and the SOC layers are repeatedly stacked.

In the vertically stacked structure, the free layer 231 may be disposed below the reference layer 21, and the SOC layer 241 may be disposed below the free layer 231. The SOC layer 241 may be used for recording a specific spin direction in the free layer 231 by using a current. In addition, the free layer 232 may be disposed below the SOC layer 241, and the SOC layer 242 may be disposed below the free layer 232. The SOC layer 242 may be used for recording a specific spin direction in the free layer 232 by using the current. In a similar pattern, the following layers may be disposed below the SOC layer 242: the free layer 233, the SOC layer 243 for recording a specific spin direction in the free layer 233, the free layer 234, and the SOC layer 244 for recording a specific spin direction in the free layer 234.

Meanwhile, the barrier layer 221 may be disposed between the reference layer 21 and the free layer 231. In addition, the barrier layer 222 may be disposed between the SOC layer 241 and the free layer 232. In addition, the barrier layers 223 and 224 may respectively be disposed between the SOC layer 242 and the free layer 233, and between the SOC layer 243 and the free layer 234.

The semiconductor device 20 may further include a plurality of transistors T1 to T4. The transistor T1 may be controlled by a word line signal WL1 to selectively connect the SOC layer 241 and a source line to each other, and the transistor T2 may be controlled by a word line signal WL2 to selectively connect the SOC layer 242 and the source line to each other. In a similar pattern, the transistor T3 or T4 may be controlled by a word line signal WL3 or WL4 to selectively connect the SOC layer 243 or 244 and the source line to each other. The SOC layer 241, 242, 243, or 244 may have one side connected to the transistor T1, T2, T3, or T4, and the other side connected to a write bit line WBL.

Meanwhile, the semiconductor device 20 may further include a readout transistor TA. The readout transistor TA may selectively connect the reference layer 21 and a readout bit line RBL to each other by a certain control signal.

The scope of the present disclosure is not limited to that shown in FIG. 8, and the number of layers included in the vertically stacked structure may be variously changed based on the specific implementation purpose and implementation environment of the stacked structure. For example, the number of repetitions of the stacked structure disposed below the reference layer 21 and the barrier layer 221 and including the free layer, the SOC layer, and the barrier layer may be changed if necessary, and there is no limit to the number of layers to be stacked as long as a process allows.

The write operation may be performed in a manner similar to that described above with reference to FIGS. 2 and 3. In detail, the transistor T1 may be turned on by the word line signal WL1, and the spin direction of the free layer 231 may be determined based on the current flowing through the SOC layer 241 between the write bit line WBL and the source line. The transistor T2 may be turned on by the word line signal WL2 after the spin direction of the free layer 231 is determined, and the spin direction of the free layer 232 may be determined based on the current flowing through the SOC layer 242 between the write bit line WBL and the source line.

In a similar manner, the transistor T3 may be turned on by the word line signal WL3 after the spin direction of the free layer 232 is determined, and the spin direction of the free layer 233 may be determined based on the current flowing through the SOC layer 243. Next, the transistor T4 may be turned on by the word line signal WL4, and the spin direction of the free layer 234 may be determined based on the current flowing through the SOC layer 244.

Hereinafter, the description describes a readout operation of identifying data recorded in the free layer 231, 232, 233, or 234 by the control of the transistor T1, T2, T3, or T4, and the transistor TA. That is, the spin directions of the free layers 231, 232, 233, and 234 may all be determined, and the spin directions of the free layers 231, 232, 233, and 234 may then be determined in a manner described below.

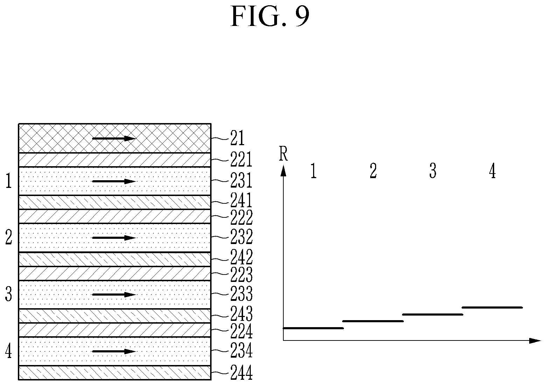

FIGS. 9 to 11 are diagrams showing the readout operation of the semiconductor device according to an embodiment.

Referring to FIG. 9, the reference layer 21 may be connected to the readout bit line RBL through the readout transistor TA, and the SOC layer 241 may be connected to the source line through the transistor T1. The spin direction of the free layer 231 may be determined by measuring a resistance value of the stacked structure including the reference layer 21, the free layer 231, and the SOC layer 241, and the barrier layer 221 disposed between these layers. As shown in the drawing, the measured resistance value may be identified as '1'.

The spin direction of the reference layer 21 and the spin direction of the free layer 231 may be determined to be opposite to each other when the resistance value identified as '1' is measured to be a predetermined fifth critical value or more, and the spin direction of the reference layer 21 and the spin direction of the free layer 231 may be determined to be the same as each other when the resistance value identified as '1' is measured to be less than the fifth critical value. FIG. 9 shows the case where the resistance value identified as '1' is less than the fifth critical value. Here, it may be seen that the spin direction of the reference layer 21 and the spin direction of the free layer 231 are the same as each other.

Next, the reference layer 21 may be connected to the readout bit line RBL through the readout transistor TA, and the SOC layer 242 may be connected to the source line through the transistor T2. The spin direction of the free layer 232 may be determined by measuring a resistance value of the stacked structure including the reference layer 21, the free layers 231 and 232, and the SOC layers 241 and 242, and the barrier layers 221 and 222 respectively disposed between these layers. As shown in the drawing, the measured resistance value may be identified as '2'.

The spin direction of the free layer 231 and the spin direction of the free layer 232 may be determined to be opposite to each other when a difference between the resistance value identified as '1' and the resistance value identified as '2' is measured to be a predetermined sixth critical value or more, and the spin direction of the free layer 231 and the spin direction of the free layer 232 may be determined to be the same as each other when the difference between the resistance value identified as '1' and the resistance value identified as '2' is measured to be less than the sixth critical value. FIG. 9 shows the case where the difference is less than the sixth critical value. Here, it may be seen that the spin direction of the free layer 231 and the spin direction of the free layer 232 are the same as each other.

Next, the reference layer 21 may be connected to the readout bit line RBL through the readout transistor TA, and the SOC layer 243 may be connected to the source line through the transistor T3. The spin direction of the free layer 233 may be determined by measuring a resistance value of the stacked structure including the reference layer 21, the free layers 231, 232, and 233, the SOC layers 241, 242 and 243, and the barrier layers 221, 222, and 223 respectively disposed between these layers. As shown in the drawing, the measured resistance value may be identified as '3'.

The spin direction of the free layer 232 and the spin direction of the free layer 233 may be determined to be opposite to each other when a difference between the resistance value identified as '2' and the resistance value identified as '3' is measured to be a predetermined seventh critical value or more, and the spin direction of the free layer 232 and the spin direction of the free layer 233 may be determined to be the same as each other when the difference between the resistance value identified as '2' and the resistance value identified as '3' is measured to be less than the seventh critical value. FIG. 9 shows the case where the difference is less than the seventh critical value. Here, it may be seen that the spin direction of the free layer 232 and the spin direction of the free layer 233 are the same as each other.

Next, the reference layer 21 may be connected to the readout bit line RBL through the readout transistor TA, and the SOC layer 244 may be connected to the source line through the transistor T4. The spin direction of the free layer 234 may be determined by measuring a resistance value of the stacked structure including the reference layer 21, the free layers 231, 232, 233, and 234, the SOC layers 241, 242, 243, and 244, and the barrier layers 221, 222, 223, and 224 respectively disposed between these layers. As shown in the drawing, the measured resistance value may be identified as '4'.

The spin direction of the free layer 233 and the spin direction of the free layer 234 may be determined to be opposite to each other when a difference between the resistance value identified as '3' and the resistance value identified as '4' is measured to be a predetermined eighth critical value or more, and the spin direction of the free layer 233 and the spin direction of the free layer 234 may be determined to be the same as each other when the difference between the resistance value identified as '3' and the resistance value identified as '4' is measured to be less than the eighth critical value. FIG. 9 shows the case where the difference is less than the eighth critical value. Here, it may be seen that the spin direction of the free layer 233 and the spin direction of the free layer 234 are the same as each other. In this manner, it is possible to identify the spin directions of all the free layers included in the vertically stacked structure.

The above-described fifth critical value, sixth critical value, seventh critical value and eighth critical value may all be set to the same value, or at least one of these values may be set to a different value.

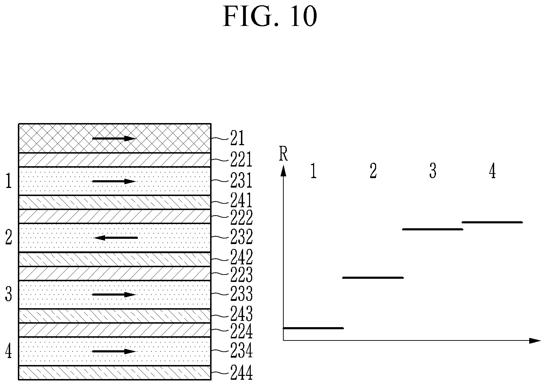

Referring to FIG. 10, the readout operation may be performed in the manner described above with respect to FIG. 9. In this case, it may be seen that the spin direction of the reference layer 21 and the spin direction of the free layer 231 are the same as each other because the resistance value identified as '1' is less than the fifth critical value, and it may be seen that the spin direction of the free layer 231 and the spin direction of the free layer 232 are opposite to each other because the difference between the resistance value identified as '1' and the resistance value identified as '2' is the sixth critical value or more. Next, it may be seen that the spin direction of the free layer 232 and the spin direction of the free layer 233 are opposite to each other because the difference between the resistance value identified as '2' and the resistance value identified as '3' is the seventh critical value or more, and it may be seen that the spin direction of the free layer 233 and the spin direction of the free layer 234 are the same as each other because the difference between the resistance value identified as '3' and the resistance value identified as '4' is less than the eighth critical value.

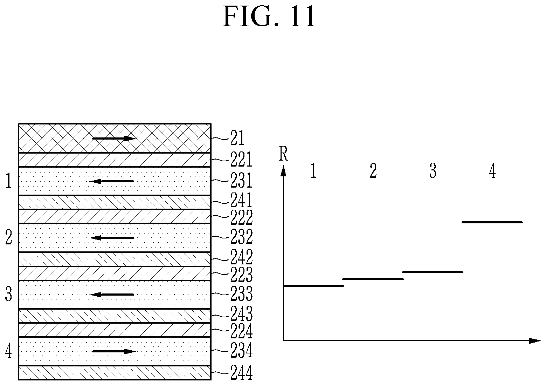

Referring to FIG. 11, the readout operation may be performed in the manner described above with respect to FIG. 9. In this case, it may be seen that the spin direction of the reference layer 21 and the spin direction of the free layer 231 are opposite to each other because the resistance value identified as '1' is the fifth critical value or more, it may be seen that the spin direction of the free layer 231 and the spin direction of the free layer 232 are the same as each other because the difference between the resistance value identified as '1' and the resistance value identified as '2' is less than the sixth critical value, it may be seen that the spin direction of the free layer 232 and the spin direction of the free layer 233 are the same as each other because the difference between the resistance value identified as '2' and the resistance value identified as '3' is less than the seventh critical value, and it may be seen that the spin direction of the free layer 233 and the spin direction of the free layer 234 are opposite to each other because the difference between the resistance value identified as '3' and the resistance value identified as '4' is the eighth critical value or more.

According to the semiconductor device 20 of the vertically stacked structure described with reference to FIGS. 8 to 11, assume for comparison that the semiconductor device 20 uses the same N free layers, that is, the same data capacity (e.g., N bits). Here, the vertically stacked structure including the N free layers may have an occupancy area reduced to about 1/N of an occupancy area of a magnetic random-access memory (MRAM) device having a conventional array form. In addition, a conventional spin orbit torque magnetic random-access memory (SOT-MRAM) may require two transistors per one magnetic tunnel junction (MTJ) for its operation. However, the vertically stacked structure according to an embodiment may require fewer transistors for the readout operation. That is, the vertically stacked structure including the N free layers may require only N+1 transistors, and thus be significantly improved over the conventional SOT-MRAM requiring 2N transistors.

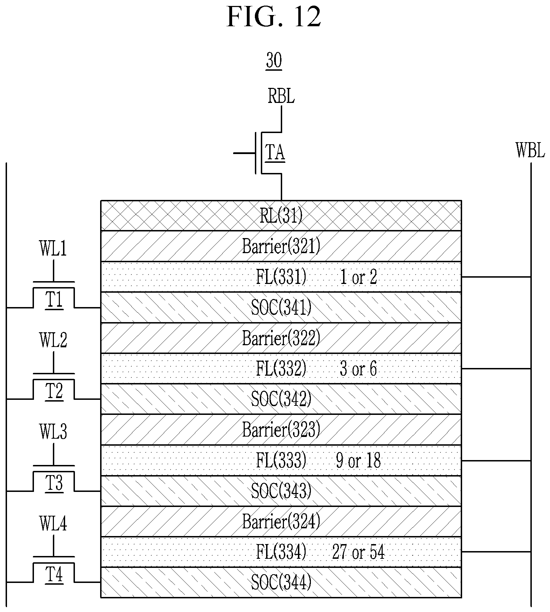

FIG. 12 is a diagram showing a semiconductor device according to still another embodiment.

Referring to FIG. 12, a semiconductor device 30 according to an embodiment may include a reference layer 31, a plurality of barrier layers 321 to 324, a plurality of free layers 331 to 334, and a plurality of spin orbit coupling (SOC) layers 341 to 344. As shown in the drawing, the semiconductor device 30 may have a vertically stacked structure in which the barrier layers, the free layers, and the SOC layers are repeatedly stacked.

In the vertically stacked structure, the free layer 331 may be disposed below the reference layer 31, the free layer 331 having a physical property in which a resistance value of the free layer 331 is determined to a value corresponding to a first digit of the ternary number, based on its spin direction. For example, the free layer 331 may be manufactured to have a resistance value determined between 1 or 2 (that is, 1₍₃₎ or 2₍₃₎) based on the spin direction. Here, the resistance value may have, for example, a unit of Ω. The SOC layer 341 may be disposed below the free layer 331, and the SOC layer 341 may have the specific spin direction recorded in the free layer 331 by using a current. In addition, the free layer 332 may be disposed below the SOC layer 341, the free layer 332 having a physical property in which a resistance value of the free layer 332 is determined to a value corresponding to a second digit of the ternary number, based on its spin direction. For example, the free layer 332 may be manufactured to have a resistance value determined between 3 or 6 (that is, 10₍₃₎ or 20₍₃₎) based on the spin direction. The SOC layer 342 may be disposed below the free layer 332, and the SOC layer 342 may have the specific spin direction recorded in the free layer 332 by using the current.

Next, the free layer 333 may be disposed below the SOC layer 342, the free layer 333 having a physical property in which a resistance value of the free layer 333 is determined to a value corresponding to a third digit of the ternary number, based on its spin direction. For example, the free layer 333 may be manufactured to have a resistance value determined between 9 or 18 (that is, 100₍₃₎ or 200₍₃₎) based on the spin direction. The SOC layer 343 may be disposed below the free layer 333, and the SOC layer 343 may have the specific spin direction recorded in the free layer 333 by using the current. In addition, the free layer 334 may be disposed below the SOC layer 343, the free layer 334 having a physical property in which a resistance value of the free layer 334 is determined to a value corresponding to a fourth digit of the ternary number, based on its spin direction. For example, the free layer 334 may be manufactured to have a resistance value determined between 27 or 54 (that is, 1000₍₃₎ or 2000₍₃₎) based on the spin direction. The SOC layer 344 may be disposed below the free layer 334, and the SOC layer 344 may have the specific spin direction recorded in the free layer 332 by using the current.

Meanwhile, the barrier layer 321 may be disposed between the reference layer 31 and the free layer 331. In addition, the barrier layer 322 may be disposed between the SOC layer 341 and the free layer 332. In addition, the barrier layers 323 and 324 may respectively be disposed between the SOC layer 342 and the free layer 333, and between the SOC layer 343 and the free layer 334.

The semiconductor device 30 may further include a plurality of transistors T1 to T4. The transistor T1 may be controlled by a word line signal WL1 to selectively connect the SOC layer 341 and a source line to each other, and the transistor T2 may be controlled by a word line signal WL2 to selectively connect the SOC layer 342 and the source line to each other. In a similar pattern, the transistor T3 or T4 may be controlled by a word line signal WL3 or WL4 to selectively connect the SOC layer 343 or 344 and the source line to each other. The SOC layer 341, 342, 343, or 344 may have one side connected to the transistor T1, T2, T3, or T4, and the other side connected to a write bit line WBL.

Meanwhile, the semiconductor device 30 may further include a readout transistor TA. The readout transistor TA may selectively connect the reference layer 31 and a readout bit line RBL to each other by a certain control signal.

The scope of the present disclosure is not limited to that shown in FIG. 12, and the number of layers included in the vertically stacked structure may be variously changed based on the specific implementation purpose and implementation environment of the vertically stacked structure. For example, the number of repetitions of the stacked structure disposed below the reference layer 31 and the barrier layer 321 and including the free layer, the SOC layer, and the barrier layer may be changed if necessary, and there is no limit to the number of layers to be stacked as long as a process allows.

The write operation may be performed in a manner similar to that described above with reference to FIGS. 2 and 3. In detail, the transistor T1 may be turned on by the word line signal WL1, and the spin direction of the free layer 331 may be determined based on the current flowing through the SOC layer 341 between the write bit line WBL and the source line. The transistor T2 may be turned on by the word line signal WL2 after the spin direction of the free layer 331 is determined, and the spin direction of the free layer 332 may be determined based on the current flowing through the SOC layer 342 between the write bit line WBL and the source line.

In a similar manner, the transistor T3 may be turned on by the word line signal WL3 after the spin direction of the free layer 332 is determined, and the spin direction of the free layer 333 may be determined based on the current flowing through the SOC layer 343. Next, the transistor T4 may be turned on by the word line signal WL4, and the spin direction of the free layer 334 may be determined based on the current flowing through the SOC layer 344.

Hereinafter, the description describes a readout operation of identifying data recorded in the free layer 331, 332, 333, or 334 by the control of the transistor T1, T2, T3, or T4, and the transistor TA. That is, the spin directions of the free layers 331, 332, 333, and 334 may all be determined, and the spin directions of the free layers 331, 332, 333, and 334 may then be determined in a manner described below.

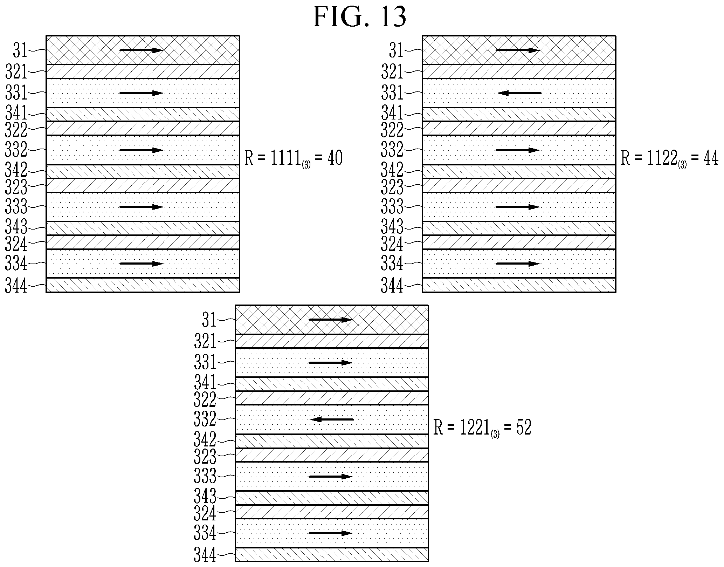

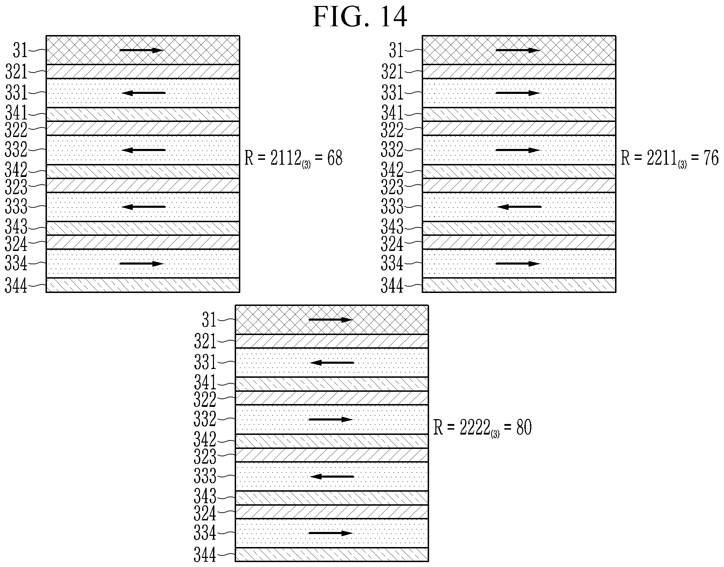

FIGS. 13 and 14 are diagrams showing the readout operation of the semiconductor device according to an embodiment.

Referring to FIG. 13, the spin direction of the free layer 331, 332, 333, or 334 may be determined by measuring the resistance value between the reference layer 31 and the SOC layer 344, and converting the measured resistance value to the ternary number.

In an embodiment, the resistance value measured between the reference layer 31 and the SOC layer 344 may be 40. In this case, 40 may be expressed as 1111 ₍₃₎ in ternary numeral system. 1111 ₍₃₎ may be 1 X 3³ + 1 X 3² + 1 X 3¹ + 1 X 3°, and a coefficient of the highest order (i.e., third order) term may be determined based on the spin direction of the free layer 334, and a coefficient of the next higher order (i.e., second order) term may be determined based on the spin direction of the free layer 333. In addition, a coefficient of the next higher order (i.e., first order) term may be determined based on the spin direction of the free layer 332, and a coefficient of the lowest order (i.e., zero-th order) term may be determined based on the spin direction of the free layer 331. Based on this corresponding relationship, the spin direction of the free layer 334 may be determined to be the spin direction of a case where the resistance value is 1 X 3³ = 27, and the spin direction of the free layer 333 may be determined to be the spin direction of a case where the resistance value is 1 X 3² = 9. In addition, the spin direction of the free layer 332 may be determined to be the spin direction of a case where the resistance value is 1 X 3¹ = 3, and the spin direction of the free layer 331 may be determined to be the spin direction of a case where the resistance value is 1 X 3° = 1. In this manner, it is possible to identify the spin directions of all the free layers included in the vertically stacked structure by only measuring the resistance value even for one time.

In another embodiment, the resistance value measured between the reference layer 31 and the SOC layer 344 may be 44. In this case, 44 may be expressed as 1122₍₃₎ in the ternary numeral system. Here, the spin direction of the free layer 334 may be determined to be the spin direction of the case where the resistance value is 1 X 3³ = 27, and the spin direction of the free layer 333 may be determined to be the spin direction of the case where the resistance value is 1 X 3² = 9. In addition, the spin direction of the free layer 332 may be determined to be the spin direction of a case where the resistance value is 2 X 3¹ = 6, and the spin direction of the free layer 331 may be determined to be the spin direction of a case where the resistance value is 2 X 3° = 2.

In still another embodiment, the resistance value measured between the reference layer 31 and the SOC layer 344 may be 52. In this case, 52 may be expressed as 1221₍₃₎ in the ternary numeral system. Here, the spin direction of the free layer 334 may be determined to be the spin direction of the case where the resistance value is 1 X 3³ = 27, and the spin direction of the free layer 333 may be determined to be the spin direction of the case where the resistance value is 2 X 3² = 18. In addition, the spin direction of the free layer 332 may be determined to be the spin direction of the case where the resistance value is 2 X 3¹ = 6, and the spin direction of the free layer 331 may be determined to be the spin direction of the case where the resistance value is 1 X 3° = 1.

Next, referring to FIG. 14, in an embodiment, the resistance value measured between the reference layer 31 and the SOC layer 344 may be 68. In this case, 68 may be expressed as 2112₍₃₎ in the ternary numeral system. Here, the spin direction of the free layer 334 may be determined to be the spin direction of a case where the resistance value is 2 X 3³ = 54, and the spin direction of the free layer 333 may be determined to be the spin direction of the case where the resistance value is 1 X 3² = 9. In addition, the spin direction of the free layer 332 may be determined to be the spin direction of a case where the resistance value is 1 X 3¹ = 3, and the spin direction of the free layer 331 may be determined to be the spin direction of the case where the resistance value is 2 X 3° = 2.
in another embodiment, the resistance value measured between the reference layer 31 and the SOC layer 344 may be 76. In this case, 76 may be expressed as 2211₍₃₎ in the ternary numeral system. Here, the spin direction of the free layer 334 may be determined to be the spin direction of the case where the resistance value is 2 X 3³ = 54, and the spin direction of the free layer 333 may be determined to be the spin direction of the case where the resistance value is 2 X 3² = 18. In addition, the spin direction of the free layer 332 may be determined to be the spin direction of the case where the resistance value is 1 X 3¹ = 3, and the spin direction of the free layer 331 may be determined to be the spin direction of the case where the resistance value is 1 X 3° = 1.
in still another embodiment, the resistance value measured between the reference layer 31 and the SOC layer 344 may be 80. In this case, 80 may be expressed as 2222₍₃₎ in the ternary numeral system. Here, the spin direction of the free layer 334 may be determined to be the spin direction of the case where the resistance value is 2 X 3³ = 54, and the spin direction of the free layer 333 may be determined to be the spin direction of the case where the resistance value is 2 X 3² = 18. In addition, the spin direction of the free layer 332 may be determined to be the spin direction of the case where the resistance value is 2 X 3¹ = 6, and the spin direction of the free layer 331 may be determined to be the spin direction of the case where the resistance value is 2 X 3° = 2.

According to the semiconductor device 30 of the vertically stacked structure described with reference to FIGS. 12 to 14, assume for comparison that the semiconductor device 30 uses the same N number of the free layers, that is, the same data capacity (e.g., N bits). Here, the vertically stacked structure including the N free layers may have an occupancy area reduced to about 1/N of an occupancy area of a magnetic random-access memory (MRAM) device having a conventional array form. In addition, a conventional spin orbit torque magnetic random-access memory (SOT-MRAM) may require two transistors per one magnetic tunnel junction (MTJ) for its operation. However, the vertically stacked structure according to an embodiment may require fewer transistors for the readout operation. That is, the vertically stacked structure including the N free layers may require only N+1 transistors, and thus be significantly improved over the conventional SOT-MRAM requiring 2N transistors. In addition, it is possible to identify the spin directions of all the free layers included in the vertically stacked structure by only measuring the resistance value even for one time.

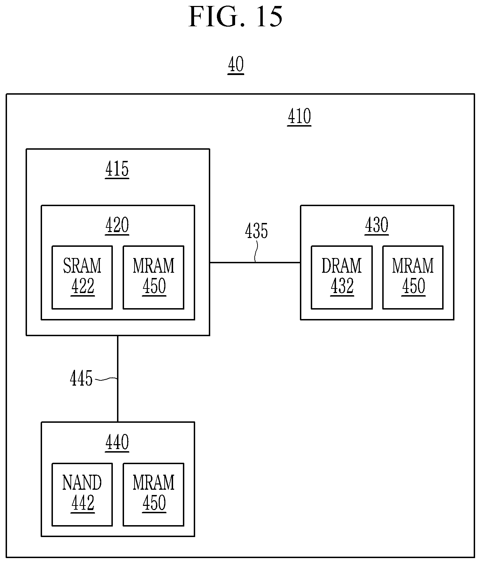

FIG. 15 is a block diagram showing a system including the semiconductor device according to an embodiment.

Referring to FIG. 15, according to an embodiment, a system 40 including the semiconductor device may include a magnetic random-access memory (MRAM) 450. The system 40 may include a computing device 410. In some embodiments, the computing device 410 may indicate any electronic device capable of computing by performing arithmetic or logical operations on the data. The computing device 410 may be, for example, a server, a workstation, a desktop computer, a laptop computer, a tablet PC, a smartphone, a control system for another electronic device, or a storage device connected to a network. In some embodiments, the computing device 410 may include a non-transitory computer-readable storage medium storing an instruction readable by a computer configured to perform one or more steps of the methods disclosed in the specification.

The computing device 410 may include a processor 415, a memory 430, and a storage 440. The processor 415 may indicate any electronic element performing the arithmetic or logical operations performed by the computing device. For example, in some embodiments, the processor 415 may be a general-purpose processor executing a stored program code. In some other embodiments, the processor 415 may be a field-programmable gate array (FPGA), an application-specific integrated circuit (ASIC), or the like, which may be operated by data stored in the memory 430 or the storage 440. In some other embodiments, the processor 415 may be a controller for a storage, a networking device, or the like.

The processor 415 may include a cache 420. In some embodiments, the cache 420 may store the data for use by the processor 415. In some embodiments, the cache 420 may be smaller and faster than the memory 430, and replicate the data to a frequently-used location in the memory 430. In some embodiments, the processor 415 may include the plurality of the cache 420. In some embodiments, the cache 420 may include at least one type of memory medium for storing the data, such as a static random-access memory (SRAM) 422 or the MRAM 450. For example, in some embodiments, the cache 420 may include the SRAM 422. In some other embodiments, the cache 420 may include the MRAM 450. In some other embodiments, the cache 420 may include a combination of the SRAM 422, the MRAM 450, and another type of storage medium.

The memory 430 may be connected to the processor 415 by a memory bus 435. In some embodiments, the memory 430 may store the data directly addressable by the processor 415. In some embodiments, the memory 430 may include at least one type of memory medium for storing the data, such as a dynamic random-access memory (DRAM) 432 or the MRAM 450. For example, in some embodiments, the memory 430 may include the DRAM 432. In some other embodiments, the memory 430 may include the MRAM 450. In some other embodiments, the memory 430 may include a combination of the DRAM 432, the MRAM 450, and another type of memory medium.

The storage 440 may be connected to the processor 115 by a storage bus 445. In some embodiments, the storage bus 445 may be a peripheral bus of the computing device 410, such as a peripheral component interconnect express (PCIe) bus, a serial advanced technology attachment (SATA) bus, a parallel advanced technology attachment (PATA) bus, a small computer system interface (SCSI) bus, a firewire bus, a universal serial bus (USB), or a PCIe advanced switching bus (PCIe-AS). In some embodiments, the storage 440 may store the data which may be accessed through at least one storage controller rather than being addressed directly by the processor 415. In some embodiments, the storage 440 may be larger than the memory 430. In some embodiments, the storage 440 may include at least one type of memory medium for storing the data, such as a hard disk drive, a NAND flash memory 442, or the MRAM 450. For example, in some embodiments, the storage 440 may include the NAND flash memory 442. In some other embodiments, the storage 440 may include the MRAM 450. In some other embodiments, the storage 440 may include a combination of the NAND flash memory 442, the MRAM 450, and another type of memory medium.

In some embodiments, the MRAM 450 may be used to store the data in the cache 420, the memory 430, the storage 440, or another component storing the data. For example, the computing device 410 may include the MRAM 450 in the cache 420, the memory 430, or the storage 440. In some other embodiments, the computing device 410 may use the MRAM 450 for the memory 430 and another type of memory or another type of storage medium for the cache 420 or the storage 440. On the contrary, in some other embodiments, the computing device 410 may use the MRAM 450 for the storage 440, and use another type of memory medium for the cache 420 or the memory 430. In addition, a certain type of computing device 410 may include the memory 430 (e.g., in a microcontroller) without the storage 440 if the memory 430 is a nonvolatile memory, or may include the memory 430 without the cache 420 for the dedicated processor 415. Various combinations of the cache 420, the memory 430, or the storage 440 and the use of the cache 420, the memory 430, the storage 440, or the MRAM 450 for another application are to become apparent considering the content disclosed in the specification.

According to the embodiments described hereinabove, the semiconductor device may provide the MRAM having the vertically stacked structure in which the tunneling barrier layers, the free layers, and the SOC layers are repeatedly stacked, thus achieving the higher bit density while miniaturizing MTJ and reducing its occupancy area. In addition, the semiconductor device may have the fewer transistors required for its operation, thereby implementing the more effective scaling down compared to the MRAM device having the conventional array form.

Although the embodiments of the present disclosure have been described in detail hereinabove, the scope of the present disclosure is not limited thereto. That is, various modifications and alterations made by those skilled in the art to which the present disclosure pertains by using a basic concept of the present disclosure as defined in the following claims also fall within the scope of the present disclosure.

## Claims

1. A semiconductor device comprising:
a reference layer having a fixed spin direction;
a first free layer disposed below the reference layer;
a first spin orbit coupling (SOC) layer disposed below the first free layer, and configured to control a spin direction recorded in the first free layer by using a current flowing through the first SOC layer;
a second free layer disposed below the first SOC layer; and
a second SOC layer disposed below the second free layer, and configured to control a spin direction recorded in the second free layer by using a current flowing through the second SOC layer.

2. The device of claim 1, further comprising:
a barrier layer disposed between the reference layer and the metal layer, between the metal layer and the first free layer, or between the first SOC layer and the second free layer.

3. The device of claim 1 or 2, further comprising:
a first transistor controlled by a first word line signal to selectively connect the metal layer and a source line to each other;
a second transistor controlled by a second word line signal to selectively connect the first SOC layer and the source line to each other; and
a third transistor controlled by a third word line signal to selectively connect the second SOC layer and the source line to each other.

4. The device of claim 3, wherein
the first SOC layer is connected to a write bit line,
the first SOC layer is connected to the source line through the second transistor, and
the spin direction of the first free layer is determined based on the current flowing through the first SOC layer, which is disposed between the write bit line and the source line.

5. The device of claim 4, wherein
the second SOC layer is connected to the write bit line,
the second SOC layer is connected to the source line through the third transistor, and
the spin direction of the second free layer is determined based on the current flowing through the second SOC layer, which is disposed between the write bit line and the source line.

6. The device of claim 3, 4 or 5,
further comprising a readout transistor configured to selectively connect the reference layer and a readout bit line to each other,
wherein the reference layer is connected to the readout bit line through the readout transistor,
the first SOC layer is connected to the source line through the second transistor, and
the spin direction of the first free layer is determined by measuring a resistance value of a first stacked structure including the reference layer, the metal layer, the first free layer, and the first SOC layer.

7. The device of claim 6, wherein
the spin direction of the reference layer and the spin direction of the first free layer are determined to be opposite to each other when the measured resistance value of the first stacked structure is a first critical value or more, and
the spin direction of the reference layer and the spin direction of the first free layer are determined to be the same as each other when the measured resistance value of the first stacked structure is less than the first critical value.

8. The device of claim 6 or 7, wherein
the metal layer is connected to the source line through the first transistor,
the second SOC layer is connected to the source line through the third transistor, and
the spin direction of the second free layer is determined by measuring a resistance value of a second stacked structure including the reference layer, the metal layer, the first free layer, the first SOC layer, the second free layer, and the second SOC layer.

9. The device of claim 8, wherein
the spin direction of the first free layer and the spin direction of the second free layer are determined to be opposite to each other when the measured resistance value of the second stacked structure is a second critical value or more, and
the spin direction of the first free layer and the spin direction of the second free layer are determined to be the same as each other when the measured resistance value of the second stacked structure is measured to be less than the second critical value.

10. The device of any preceding claim, further comprising:
a metal layer disposed below the reference layer,
and wherein the first free layer is disposed below the reference layer.

11. The device of any preceding claim,
wherein the first free layer has a physical property in which a resistance value of the first free layer is determined to a value corresponding to a first digit of a ternary number, based on a spin direction of the first free layer,
and wherein the second free layer has a physical property in which a resistance value of the second free layer is determined to a value corresponding to a second digit of the ternary number, based on a spin direction of the second free layer.

12. The device of claim 11, wherein
the spin directions of the first free layer and the second free layer are determined by converting a resistance value measured between the reference layer and the second SOC layer to the ternary number.
